Europäisches Patentamt

European Patent Office

Office européen des brevets

(11) Veröffentlichungsnummer: **0 201 745**
**B1**

(12) **EUROPÄISCHE PATENTSCHRIFT**

(45) Veröffentlichungstag der Patentschrift:
14.06.89

(21) Anmeldenummer: 86105248.8

(22) Anmeldetag: 16.04.86

(51) Int. Cl.⁴: **H 01 L 31/02**

(54) **Solarzelle.**

(30) Priorität: 04.05.85 DE 3516117

(43) Veröffentlichungstag der Anmeldung:
20.11.86 Patentblatt 86/47

(45) Bekanntmachung des Hinweises auf die Patenterteilung:
14.06.89 Patentblatt 89/24

(84) Benannte Vertragsstaaten:
FR GB IT

(56) Entgegenhaltungen:
DE-A- 2 818 237
FR-A- 2 217 808
FR-A- 2 505 556
GB-A- 2 062 351
US-A- 4 320 248
US-A- 4 331 703
US-A- 4 375 007

(73) Patentinhaber: TELEFUNKEN electronic GmbH,
Theresienstrasse 2, D-7100 Heilbronn (DE)

(72) Erfinder: Friedrich, Gerda, Nordstrasse 26,
D-7101 Unterheinriet (DE)
Erfinder: Rasch, Klaus-Dieter, Dr.,
Hundsbergstrasse 10/1, D-7129 Talheim (DE)
Erfinder: Schmidt, Wilfried, Schilierstrasse 11,
D-7129 Talheim (DE)

(74) Vertreter: Maute, Hans-Jürgen, Dipl.-Ing., TELEFUNKEN
electronic GmbH Theresienstrasse 2, D-7100 Heilbronn
(DE)

## Beschreibung

Die Erfindung betrifft eine Solarzelle aus einem, einen pn-Übergang enthaltenden Halbleiterkörper, der auf der für die Lichteinstrahlung vorgesehenen Oberflächenseite mit einer reflexionsmindernden Schicht versehen ist und auf der gegenüberliegenden Oberflächenseite einen Rückseitenkontakt aufweist.

Silizium-Solarzellen werden zur Erhöhung ihres Umwandlungswirkungsgrades mit einer Anti-Reflexionsschicht auf der für den Lichteinfall vorgesehenen Oberflächenseite versehen. Diese reflexionsmindernde Schicht besteht aus einem isolierenden Material und darf daher bei bekannten Solarzellenanordnungen den für die Weiterverbindung zu anderen Zellen vorgesehenen Vorderseitenkontakt nicht bedecken. Die Dicke der reflexionsmindernden Schicht wird so gewählt, daß das Minimum der Reflexion bei ca. 600 nm auftritt. Es handelt sich im allgemeinen um eine $\lambda/4$-Schicht eines Oxids mit einem Brechungsindex von 1,4 bis 2,4. Die reflexionsmindernde Schicht vermindert das Reflexionsvermögen der Solarzellenoberfläche im Wellenlängenbereich zwischen 0,3 bis 1,2 µm von ca. 30% auf weniger als 10%, so daß der Solarzellenwirkungsgrad erheblich erhöht wird.

Aus der DE-OS 2 944 185 ist bereits eine Solarzelle bekannt, bei der die reflexionsmindernde Schicht die Metallisierung des Vorderseitenkontaktes an der Solarzelle vollständig bedeckt und die Verbindung zwischen diesem Vorderseitenkontakt und weiterführenden Zuleitungen durch Ultraschallschweißen herbeigeführt wird, wobei die zwischen den Kontaktstellen liegende reflexionsmindernde Schicht beim Schweißvorgang lokal beseitigt wird.

Aus FR-A-2 505 556 ist eine Solarzelle bekannt, bei der der Vorderseitenkontakt direkt auf der reflexionsmindernden Schicht aufgebracht ist.

Der Erfindung liegt die Aufgabe zugrunde, eine Solarzelle anzugeben, die auf sehr einfache Weise kontaktiert werden kann, ohne daß das Ultraschallschweißverfahren eingesetzt werden muß. Die erfindungsgemäße Solarzelle soll insbesondere im Bereich geringer Beleuchtungsstärken besonders gut einsetzbar sein. Diese Aufgabe wird bei einer Solarzelle der eingangs genannten Art erfindungsgemäß dadurch gelöst, daß mindestens ein Vorderseitenkontakt direkt auf die reflexionsmindernde Schicht aus isolierendem Material aufgebracht ist, so daß die Ladungsträger vom Halbleiterkörper zum Vorderseitenkontakt durch Durchtunnelung der reflexionsmindernden Schicht gelangen.

Bei der erfindungsgemäßen Solarzelle wird somit keine direkte Verbindung zwischen dem Halbleiterkörper und dem auf der reflexionsmindernden Schicht angeordneten Anschlußkontakt hergestellt, sondern der dazwischenliegende dünne Bereich der reflexionsmindernden und gleichzeitig isolierenden Schicht wird von den Ladungsträgern durchtunnelt.

Der Vorderseitenkontakt liegt in der Projektion über einem ohmschen Metallanschlußkontakt am Halbleiterkörper, der als Gitter oder einfache Leitbahn ausgebildet sein kann. Bei einer bevorzugten Weiterbildung der Erfindung wird auf diesen ohmschen Metallanschlußkontakt ganz verzichtet, so daß der Strom direkt aus dem Halbleiterkörper über die reflexionsmindernde Schicht zum Vorderseitenkontakt auf der reflexionsmindernden Schicht abgezogen wird.

Die erfindungsgemäße Ausbildung der Solarzelle empfiehlt sich insbesondere für die Verwendung im niederen Strahlungsintensitätsbereich. Bei geringen Beleuchtungsstärken von weniger als 500 Lux fließt im Halbleiterkörper ein Strom von weniger als 50 µA/cm². Der durch diesen Strom verursachte Spannungsabfall im Halbleiterkörper und am Serienwiderstand der reflexionsmindernden Schicht ist vernachlässigbar klein. Daher ist es auch möglich, den ohmschen Anschlußkontakt auf der Halbleiteroberfläche nur als Leitbahn auszubilden oder auf diesen Anschlußkontakt völlig zu verzichten. Die Erfindung und ihre vorteilhafte Ausgestaltung soll nachstehend noch anhand von Ausführungsbeispielen erläutert werden.

Fig. 1 zeigt im Schnitt eine Solarzelle mit einem Vorderseitenanschlußkontakt auf der reflexionsmindernden Schicht.

Fig. 2 zeigt die Draufsicht auf diese Solarzelle.

In Fig. 3 ist eine Solarzelle dargestellt, bei der auf einen Metallanschlußkontakt unmittelbar an der Vorderseite des Halbleiterkörpers verzichtet wird.

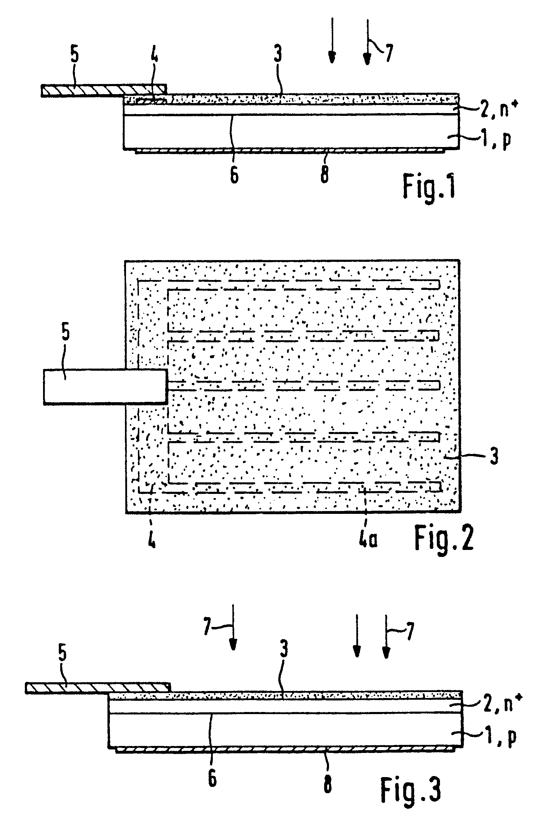

Die Solarzelle der Figur 1 besteht beispielsweise aus einer p-leitenden kristallinen Silizium-Halbleiterscheibe mit einer Dicke von 100 bis 500 µm und einer Leitfähigkeit zwischen 0,1 und 10 ($\Omega$cm$^{-1}$). Als Halbleitermaterial eignen sich neben einkristallinem oder polykristallinem Silizium auch amorphes Silizium oder III/V-Verbindungen. Der Halbleiterkörper enthält einen durch Diffusion, Implantation oder Epitaxie hergestellten pn-Übergang 6 zur Bildung einer Oberflächenschicht 2, die bei einem p-dotierten Grundmaterial 1 n$^+$-leitend ist. Die n$^+$-leitende Schicht 2 hat beispielsweise eine Dicke von 0,3 bis 0,6 µm und einen Schichtwiderstand von 20 bis 120 $\Omega/\square$ bei einer kristallinen Silizium-Solarzelle. Auf der Halbleiterschicht 2 ist ein ohmscher Anschlußkontakt 4 angeordnet, der aus Aluminium oder aus Titan-Palladium-Silber besteht. Für den Metallkontakt kommen jedoch auch Materialien wie Gold, Chrom, Gold-Chrom-Kombinationen, Silber, Nickel oder ein leitfähiges Oxid in Frage. Der Kontakt, der gemäß der Draufsicht nach Figur 2, die Form eines Leitbahnstreifens 4 mit davon fingerförmig ausgehenden Streifen 4a hat, kann aufgedampft, aufgedruckt oder elektrolytisch abgeschieden werden.

Die gesamte Vorderseite des Halbleiterkörpers, die für den Lichteinfall 7 vorgesehen ist, wird sodann noch mit einer reflexionsmindernden Schicht 3 bedeckt. Diese reflexionsmindernde Schicht besteht aus Titanoxid oder aus einem Titanmischoxid, Siliziummonoxid, Siliziumdioxid, Siliziumnitrid, Tantaloxid, Nioboxid oder Aluminiumoxid. Es ist auch möglich, daß die Antireflexionsschicht mehrere der genannten Bestandteile enthält oder insgesamt mehrschichtig aufgebaut wird, sie hat eine Dicke von beispielsweise 70 nm. Die reflexionsmindernde Schicht 3 kann thermisch erzeugt werden, aufgedampft, aufgeschleudert, aufgedruckt, aufgesprüht oder durch Tauchen hergestellt werden.

Bei Solarzellen für niedere Intensitätsbereiche ist es ausreichend, wenn der Kontakt 4 nur leitbahnförmig ausgebildet ist, da bei den vorhandenen niedrigen Stromstärken der Spannungsabfall in der Halbleiterschicht 2 vernachlässigt werden kann.

Auf die reflexionsmindernde Schicht wird schließlich der Vorderseitenkontakt 5 aufgebracht, der in der Projektion, zumindest in einem Teilbereich über dem ohmschen Anschlußkontakt 4 liegt, so daß die Ladungsträger auf ihrem Weg vom Halbleiterkörper in den Vorderseitenkontakt nur die Antireflexionsschicht durchtunneln müssen. Der Vorderseitenkontakt 5 kann aus einem Leitkleber, aus aufgeklebten Leitbahnen oder aufgeklebten Drähten bestehen. Er wird vorzugsweise so ausgebildet, daß er über den seitlichen Rand des Halbleiterkörpers hinausragt und somit als Verbinder zu weiteren Solarzellen, die in ihrer Gesamtheit eine Solarzellenbatterie bilden, dienen kann. Die Leitbahnen 5 werden vorzugsweise auf die Antireflexionsschicht 3 aufgeklebt. Auch Drähte aus Metall sind verwendbar, die beispielsweise mit thermisch aktivierbarem Kleber oder Leitkleber beschichtet sind, so daß beim Aufpressen eine feste Verbindung zwischen dem Draht und der Antireflexionsschicht zustande kommt.

Zur Kontakterzeugung können auch Leitkleber verwendet werden; dies sind mit Silber, Graphit, Gold, Kupfer oder Nickel gefüllte Epoxydharze, Acrylharze oder Polyimidkleber, die durch Siebdruck, Stempeltechniken oder auch flüssig aufgetragen und danach zur Aushärtung getempert werden. Es sind auch thermisch aktivierbare, leitfähige Kleber verwendbar, die erst unter Einsatz von Druck und Temperatur ihre Klebefähigkeit entwickeln. Solche Kleber sind handelsüblich erhältlich. Die genannten Leitkleber oder thermisch aktivierbaren Kleber werden vorzugsweise auf einen isolierenden Träger aufgebracht, der beispielsweise aus einer Kunststoffolie oder einer Glasscheibe besteht. Dieser beschichtete Träger wird so auf die Vorderseite der Solarzelle aufgebracht, daß die leitende Schicht mit der Antireflexionsschicht in Verbindung kommt und, gestützt durch den Träger, über den seitlichen Rand der Solarzelle in der dargestellten Weise hinausragt. Der Trägerkörper ist vorzugsweise lichtdurchlässig.

Die Figur 3 zeigt noch eine Variation der erfindungsgemäßen Solarzelle, bei der der ohmsche Anschlußkontakt 4 an der Halbleiterschicht 2 weggelassen wird. Der Stromfluß erfolgt somit direkt aus der Halbleiterschicht 2 durch die reflexionsmindernde Schicht 3 zum Vorderseitenkontakt 5. Dies ist wiederum dann möglich, wenn die Solarzelle bei niederer Beleuchtungsstärke unter ca. 500 Lux eingesetzt wird, da dann der durch die Solarzelle fließende Strom im µA-Bereich vernachlässigbar kleine Spannungsabfälle im Halbleiterkörper und in der reflexionsmindernden Schicht verursacht.

In den Figuren 1 und 3 ist noch jeweils der Rückseitenkontakt an der Solarzelle mit 8 bezeichnet. Der erfindungsgemäßen Solarzellen eignen sich insbesondere für den Einsatz im Konsumbereich, beispielsweise zum Aufbau von Solarzellenmodulen für Taschenrechner oder andere Kleingeräte. Die Solarzellen selbst haben hierbei eine relativ kleine Fläche von ca. 1 cm², so daß eine ausreichend gute Stromabfuhr durch die Vorderseitenkontakte möglich ist, ohne daß diese einen wesentlichen Teil des Halbleiterkörpers 1, 2 überdecken.

## Patentansprüche

1. Solarzelle aus einem, einen pn-Übergang (6) enthaltenden Halbleiterkörper (1, 2), der auf der für die Lichteinstrahlung (7) vorgesehenen Oberflächenseite mit einer reflexionsmindernden Schicht (3) versehen ist und auf der gegenüberliegenden Oberflächenseite einen Rückseitenkontakt (8) aufweist, dadurch gekennzeichnet, daß mindestens ein Vorderseitenkontakt (5) direkt auf die reflexionsmindernde Schicht (3) aus isolierendem Material aufgebracht ist, so daß die Ladungsträger vom Halbleiterkörper (1, 2) zum Vorderseitenkontakt (5) durch Durchtunnelung der reflexionsmindernden Schicht (3) gelangen.

2. Solarzelle nach Anspruch 1, dadurch gekennzeichnet, daß der Vorderseitenkontakt (5) über einem unter der reflexionsmindernden Schicht (3) liegenden ohmschen Metallanschlußkontakt (4), der die Oberflächenschicht (2) des Halbleiterkörpers kontaktiert, angeordnet ist.

3. Solarzelle nach Anspruch 1, dadurch gekennzeichnet, daß der Vorderseitenkontakt (5) auf der reflexionsmindernden Schicht (3) angeordnet ist, ohne daß an der Vorderseite des Halbleiterkörpers unter der reflexionsmindernden Schicht (3) ein ohmscher Anschlußkontakt vorgesehen ist.

4. Solarzelle nach einem der vorangehenden Ansprüche, dadurch gekennzeichnet, daß die Vorderseitenkontakte (5) aus Leitklebern, aufgeklebten Leitbahnen oder aufgeklebten Drähten bestehen.

5. Solarzelle nach einem der vorangehenden Ansprüche, dadurch gekennzeichnet, daß die reflexionsmindernde Schicht (3) aus $TiO_x$ besteht und ca. 0,07 µm dick ist.

6. Solarzelle nach einem der vorangehenden Ansprüche, gekennzeichnet durch die Verwendung im niederen Strahlungs-Intensitätsbereich.

7. Solarzelle nach Anspruch 6, gekennzeichnet durch die Verwendung bei Beleuchtungsstärken bis zu ca. 500 Lux.

## Claims

1. A solar cell of a semiconductor body (1, 2) containing a pn-junction (6), which body is provided on the surface side provided for the light irradiation (7) with a reflection-reducing layer (3) and has a rear contact (8) on the opposite surface side, characterized in that at least one front contact (5) is directly applied onto the reflection-reducing layer (3) of insulating material so that the charge carrier from the semiconductor body (1, 2) reach the front contact (5) by tunnelling through the reflection-reducing layer (3).

2. A solar cell according to Claim 1, characterized in that the front contact (5) is arranged over an ohmic metal connection contact (4) lying under the reflection-reducing layer (3), which contact contacts the upper surface layer (2) of the semiconductor body.

3. A solar cell according to Claim 1, characterized in that the front contact (5) is arranged on the reflection-reducing layer (3) without an ohmic connection contact being provided on the front of the semiconductor body under the reflection-reducing layer (3).

4. A solar cell according to any one of the preceding Claims, characterized in that the front contacts (5) consist of conducting adhesives, bonded conductive tracks or bonded wires.

5. A solar cell according to any one of the preceding Claims, characterized in that the reflection-reducing layer (3) consists of $TiO_x$ and is approximately 0.07 µm thick.

6. A solar cell according to any one of the preceding Claims, characterized by use in the lower radiation intensity range.

7. A solar cell according to claim 6, characterized by use with illuminances of up to approximately 500 lux.


### Revendications

1. Cellule solaire faite d'un corps semiconducteur (1, 2) qui contient une jonction pn (6) et qui, sur le côté prévu pour être exposé à la lumière (7), est muni d'une couche (3) réduisant la réflexion, et présente, sur le côté opposé, un contact de côté arrière (8), caractérisée par le fait qu'au moins un contact de côté avant (5) est appliqué directement sur la couche (3) réduisant la réflexion, faite d'une matière isolante, de sorte que les porteurs de charge vont du corps semiconducteur (1, 2) au contact (5) du côté avant en franchissant par effet tunnel la couche (3) réduisant la réflexion.

2. Cellule solaire selon la revendication 1, caractérisée par le fait que le contact (5) du côté avant est agencé au-dessus d'un contact de raccordement ohmique métallique (4) qui est au contact de la couche superficielle (2) du corps semiconducteur et est situé en dessous de la couche (3) réduisant la réflexion.

3. Cellule solaire selon la revendication 1, caractérisée par le fait que le contact (5) du côté avant est agencé sur la couche (3) réduisant la réflexion, sans qu'un contact de raccordement ohmique soit prévu sur le côté avant du corps semiconducteur, en dessous de la couche (3) réduisant la réflexion.

4. Cellule solaire selon l'une des revendications précédentes, caractérisée par le fait que les contacts (5) du côté avant sont constitués par des colles conductrices, des pistes conductrices rapportées par collage, ou par des fils rapportés par collage.

5. Cellule solaire selon l'une des revendications précédentes, caractérisée par le fait que la couche (3) réduisant la réflexion est en $TiO_x$ et est épaisse d'environ 0,07 µm.

6. Cellule solaire selon l'une des revendications précédentes, caractérisée par son utilisation dans le domaine inférieur des valeurs d'éclairement.

7. Cellule solaire selon la revendication 6, caractérisée par son utilisation à des valeurs d'éclairement allant jusqu'à environ 500 lux.

Fig.1

Fig.2

Fig.3